# EUROPEAN PATENT SPECIFICATION

(11) **EP 3 659 211 B1**
(45) Date of publication and mention of the grant of the patent: **01.07.2026**
(21) Application number: 18746699.0
(22) Date of filing: 27.07.2018
(51) Int. Cl.: H01Q 1/22, H01Q 1/38, H01Q 1/52, H01Q 23/00, H05K 1/02, H05K 1/185, H05K 3/46

(54) **ANTENNA STRUCTURE ON HIGH-FREQUENCY DIELECTRIC IN CAVITY OF COMPONENT CARRIER**
ANTENNENSTRUKTUR AUF HOCHFREQUENZDIELEKTRIKUM IM HOHLRAUM EINES KOMPONENTENTRÄGERS
STRUCTURE D'ANTENNE SUR DIÉLECTRIQUE HAUTE FRÉQUENCE DANS UNE CAVITÉ D'UN SUPPORT DE COMPOSANT

(30) Priority: 28.07.2017 CN 201710630189
(43) Date of publication of application: 03.06.2020
(73) Proprietor: AT & S Austria Technologie & Systemtechnik Aktiengesellschaft, 8700 Leoben (AT)
(72) Inventor: GROBER, Gernot, 8741 Weißkirchen (AT)
(74) Representative: Donatello, Daniele
(86) International application number: PCT/EP2018/070427
(87) International publication number: WO 2019/020795

(56) References cited:
- WO-A1-2007/149046
- WO-A1-2016/120254
- WO-A1-2017/025552
- WO-A1-2017/068130
- US-A1- 2012 188 138
- DONG GUN KAM ET AL: "Organic Packages With Embedded Phased-Array Antennas for 60-GHz Wireless Chipsets", IEEE TRANSACTIONS ON COMPONENTS, PACKAGING AND MANUFACTURING TECHNOLOGY, IEEE, USA, vol. 1, no. 11, 30 November 2011 (2011-11-30), pages 1806 - 1814, XP011389486, ISSN: 2156-3950, DOI: 10.1109/TCPMT.2011.2169064

## Description

The invention relates to a method of manufacturing a component carrier, and to a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

In particular, efficient antenna structure operation in connection with a component carrier is a challenge.

Document WO 2017/025552 A1 discloses a component carrier having an embedded high-frequency dielectric exposed to the external environment by a cavity passing through several layers composing the component carrier. On the exposed side of the high-frequency dielectric an antenna structure is provided.

Document WO 2017/068130 A1 discloses the interconnection of one component carrier body into a cavity of a further component carrier body, one component carrier body could be high-frequency suitable, and the other non-high-frequency suitable.

It is an object of the invention to integrate an antenna structure in a component carrier in a way to allow for an efficient and reliable operation.

In order to achieve the object defined above, a method of manufacturing a component carrier, and a component carrier according to the independent claims are provided.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "antenna structure" may particularly denote an arrangement of metallic conductor elements electrically connected for instance through a transmission line to a receiver or transmitter. Hence, an antenna structure may be denoted as an electrical member which converts electric power into radio waves, and/or *vice versa.* An antenna structure may be used with a controller (for instance a control chip) such as a radio transmitter and/or radio receiver. In transmission, a radio transmitter may supply an electric current oscillating at radio frequency (i.e. a high frequency alternating current) to the antenna structure's terminals, and the antenna structure may radiate the energy from the current as electromagnetic waves (in particular radio waves). In a reception mode, an antenna structure may intercept some of the power of an electromagnetic wave in order to produce a tiny voltage at its terminals, that may be applied for example to a receiver to be amplified. In embodiments, the antenna structure may be configured as a receiver antenna structure, a transmitter antenna structure, or as a transceiver (i.e. transmitter and receiver) antenna structure.

In the context of the present application, the term "high-frequency dielectric" may particularly denote an electrically insulating material which has low loss properties when a high-frequency or radiofrequency signal propagates from or to an antenna structure in the direct environment of the high-frequency dielectric. In particular, the high-frequency dielectric may have a lower loss than standard prepreg material of a stack of component carrier material. As an example, RO3003^{™} material, as commercialized by the company Rogers Corporation, can be used as high-frequency dielectric. For instance, high-frequency dielectric material may have a dissipation factor of not more than 0.005, in particular of not more than 0.003, more particularly not more than 0.0015, at 10 GHz. The mentioned high frequency circuit materials may be for example ceramic-filled PTFE (polytetrafluoroethylene) composites.

In the context of the present application, the term "cavity" may particularly denote a recess in a surface region of a stack of a component carrier. For instance, such a recess may be a blind hole, a pair of blind holes separated by a portion of the stack (in particular a high-frequency dielectric of the stack), or a through hole. Sidewalls delimiting the cavity in a lateral direction may be oriented vertically, i.e. with a 90° angle relative to a main surface of the component carrier. However, it is alternatively also possible that the sidewalls are slanted, i.e. form an angle (in particular an acute angle) with a main surface of the component carrier deviating from 90°. Adaptation of such a slanted angle may be carried out in order to adjust an emission angle according to which emission of electromagnetic radiation is carried out and/or to adjust a reception angle according to which electromagnetic radiation entering the cavity is captured.

According to an exemplary embodiment of the invention, a component carrier with integrated antenna function is provided, in which an antenna structure is arranged mechanically protected and electromagnetically efficiently in a cavity. By such a placement of the antenna structure in the cavity, the antenna structure is prevented from mechanical damage due to load from an environment which may act on the component carrier in applications involving harsh conditions. At the same time, the antenna structure may be directly located on the high-frequency dielectric so that an operation of the component carrier with low loss even at high frequencies can be guaranteed. Moreover, the cavity at the bottom of which the antenna structure may be positioned may function as a sort of horn so that electromagnetic radiation can be focused or directed from the antenna structure to an environment, or *vice versa.* When configuring the high-frequency dielectric to constitute only part of a layer of the stack, the provision of a corresponding high-frequency material deviating from remaining dielectric material of the stack may be limited to the region where it is functionally absolutely necessary. This allows manufacturing the component carrier with low effort and with a high degree of material homogeneity over large portions of the stack.

In the following, further exemplary embodiments of the method and the component carrier will be explained.

In an embodiment, the antenna structure is formed as at least part of a patterned one of the plurality of electrically conductive layer structures. Integrating the antenna structure in the electrically conductive part of the component carrier material renders the component carrier as a whole highly compact.

In an embodiment, the antenna structure is entirely located within the cavity (in particular without protruding beyond the cavity in a vertical and/or lateral direction). Thus, a particularly pronounced mechanical protection of the antenna structure from mechanical damage during use can be achieved.

In an embodiment, sidewalls of the cavity are made of a material being at least partially reflective for electromagnetic radiation being emittable and/or detectable by the antenna structure. Such a reflective coating can be manufactured by plating. Reflecting the electromagnetic radiation at the sidewalls of the cavity increases the yield in terms of electromagnetic radiation energy being emitted and/or being received by the antenna structure. In other words, undesired absorption of electromagnetic radiation energy by component carrier material may be efficiently suppressed by taking such a measure. For instance, the reflective material may be designed so that electromagnetic radiation emitted by the antenna structure is at least partially reflected by the reflective material so as to propagate out of the cavity in a focused way towards a destination. It is also possible that the reflective material is designed so that electromagnetic radiation impinging from an environment into the cavity is at least partially reflected by the reflective material so as to be focused onto the antenna structure.

In an embodiment, the antenna structure is configured as a directional antenna structure. A directional antenna structure may be denoted as an antenna structure which radiates or receives greater power in specific directions allowing for increased performance and reduced interference from unwanted sources. Directional antennas provide increased performance over dipole antennas or omnidirectional antennas when greater concentration of radiation in a certain direction is desired. The design of the antenna structure within the cavity is strongly in favor of a configuration of such antenna structure as a directional antenna.

In an embodiment, the high-frequency dielectric forms only part of one of the electrically insulating layer structures. This allows keeping the amount of costly high-frequency material very small.

In an embodiment, the high-frequency dielectric extends, on one or two sides, beyond the lateral extension of the cavity, but not up to the sidewalls of the stack. This embodiment combines the advantages of a small high-frequency dielectric body with a high mechanical integrity of the high-frequency dielectric within the stack.

In an embodiment, the component carrier comprises an electromagnetic radiation shielding structure configured for shielding electromagnetic radiation from propagating between the antenna structure and another portion of the component carrier (for instance at least part of the stack). Such a highly advantageous electromagnetic radiation shielding structure may prevent undesired crosstalk of electromagnetic radiation between the antenna structure on the one hand, and at least one component (which may for instance be surface mounted on and/or embedded in the component carrier) and/or an electronic environment of the component carrier and/or another antenna structure of the component carrier on the other hand.

In an embodiment, the electromagnetic radiation shielding structure is at least partially integrated in the high-frequency dielectric. This allows combining an efficient electromagnetic radiation shielding function with a compact design. Moreover, this ensures the shielding to be carried out spatially very close to the antenna structure(s), and thus very efficiently close to the source or the destination of the radio frequency waves.

In an embodiment, the electromagnetic radiation shielding structure forms part of a boundary wall of the cavity. Such an efficient electromagnetic radiation shielding function can be manufactured simply by plating.

In an embodiment, the component carrier comprises a flex region being flexibly bendable. Such a flex region may be formed, completely or partially, by a bendable high-frequency dielectric. Thus, the high-frequency dielectric may be at least partially located within the flex region.

In an embodiment, the manufacturing method comprises forming the cavity by embedding a release layer in an interior of the stack and subsequently removing stack material above the release layer. Such a release layer may a layer (for instance made of a waxy material) on which other component carrier material of the stack does not properly adhere. Cutting a circumferentially closed hole above such a release layer may therefore allow to take out a piece of the stack above the release layer to thereby complete formation of the cavity. Such a procedure increases the freedom of design in terms of usable materials for the stack. In contrast to this, when forming a cavity by milling, fully cured prepreg needs to be used which limits the freedom of a component carrier designer to freely define the build-up.

In another embodiment, the manufacturing method comprises forming the cavity by forming a hollow space, at least partially surrounded by low flow prepreg or no flow prepreg, in an interior of the stack and subsequently removing stack material above the hollow space. When laminating a corresponding stack by applying mechanical pressure and/or heat, the material of the low flow prepreg or no flow prepreg is advantageously prevented from flowing into the hollow space. By subsequently cutting out a portion of the stack above the hollow space, it is possible to complete formation of the cavity with low effort while simultaneously ensuring a uniform cutting edge.

In an embodiment, the method comprises providing the stack with a cavity as a pre-cut hole in low-flow prepreg or no-flow prepreg as at least one of the electrically insulating layer structures. Thus, it is also possible that one layer, multiple layers or even all layers above the high-frequency material are made of pre-cut no-flow prepreg or low-flow prepreg. Advantageously, no-flow prepreg or low-flow prepreg will not or substantially not re-melt/not become flowable during lamination, so that a hole next to such material will not be closed during laminating by liquefied resin or the like. When laminating a corresponding stack by applying mechanical pressure and/or heat, the material of the low-flow prepreg or no-flow prepreg is thus advantageously prevented from flowing into a hollow space. In the latter mentioned embodiment, a procedure of subsequently cutting out of a portion of the stack above the hollow space can be dispensable.

At least one component may be surface mounted on and/or embedded in the component carrier. The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, a logic chip, a light guide, and an energy harvesting unit. However, other components may be embedded in or surface mounted on the component carrier. For example, a magnetic element can be used as a component. Such a magnetic element may be a permanent magnetic element (such as a ferromagnetic element, an antiferromagnetic element or a ferrimagnetic element, for instance a ferrite coupling structure) or may be a paramagnetic element. However, the component may also be a further component carrier, for example in a board-in-board configuration.

As mentioned above, the component carrier may comprise a stack of at least one electrically insulating layer structure and/or at least one electrically conductive layer structure. For example, the component carrier may be a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further components and being nevertheless very thin and compact. The term "layer structure" may particularly denote a continuous layer, a patterned layer or a plurality of non-consecutive islands within a common plane.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

In an embodiment, the component carrier is a laminate-type body. In such an embodiment, the component carrier is a compound of multiple layer structures which are stacked and connected together by applying a pressing force, if desired accompanied by heat.

The aspects defined above and further aspects of the invention are apparent from the examples of embodiment to be described hereinafter and are explained with reference to these examples of embodiment.
Figure 1 illustrates a cross-sectional view of a component carrier according to the invention.
Figures 2 to Figure 5 illustrate cross-sectional views of component carriers not belonging to the invention, for illustrative purpose.
Figure 6 shows a cross-sectional view of a structure obtained during carrying out a method of manufacturing a cavity of a component carrier according to an exemplary embodiment of the invention.
Figure 7 shows a cross-sectional view of a structure obtained during carrying out a method of manufacturing a cavity of a component carrier according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a component carrier with a highly reliable integrated radio frequency region is provided. More specifically, a protected, highly reliable integrated high-frequency area may be foreseen in such a component carrier.

Integrating a radio frequency functionality in a component carrier such as a printed circuit board (PCB) involves certain requirements in terms of dielectric materials. For instance, high-frequency materials provided by Rogers Corporation may be used which are conventionally required to be used as full layers. This involves a significant cost effort and also generates a spatially extended material bridge along a large portion of the component carrier. Conventionally, such antenna structures are arranged at an outer surface of the component carrier, which renders an antenna structure prone to failure due to mechanical damage. These and other shortcomings conventionally limit the reliability of component carriers with integrated antenna structure.

In view of the foregoing, an exemplary embodiment of the invention provides a component carrier allowing obtaining a highly reliable integration of a high frequency dielectric inlay and electrically conductive structures on component carrier level forming an antenna structure. The high-frequency region of the component carrier composed of antenna structure and high frequency dielectric can also be properly mechanically protected from damage by its location within the cavity and/or within the stack. The described design is also highly compatible with the realization of multiple antenna structures with different properties (for instance one antenna structure with a wide range function and another antenna structure in the same component carrier with a near field communication function) in one common physical body.

In a simple embodiment, the component carrier compound comprises at least two electrically insulating layer structures in which a high frequency dielectric may be inserted. Optionally, it is possible to cover the mentioned structure with at least one further electrically insulating layer structure at least partially above the high-frequency region. This renders it possible to provide one or more antenna structures in one or more cavities in one or both opposing main surfaces of a component carrier with high reliability.

For a further increased reliability, it is possible that one of the electrically insulating layer structures covers the high-frequency region completely. In order to prevent or at least significantly suppress warpage and/or for properly shielding the region it is further advantageous to provide the overlapping layers with warpage balancing materials (such as TD002) rather than with standard FR4 materials.

Exposing the region of the antenna structure can be accomplished by one of various possible cavity formation procedures. In one corresponding embodiment, formation of a buried release layer is used for cavity formation, followed by cutting out a section above the non-adhering release layer. It is however also possible to form a cavity by milling material of the stack and/or by providing buried hollow portions surrounded by low flow prepreg or no flow prepreg. A portion of the stack above such a hollow portion may then be removed for completing cavity formation. If however one or more layers above are made of pre-cut low-flow prepreg or no-flow prepreg already having a cavity which is not closed during lamination, such a material removal procedure may be dispensable. Also a combination of multiple of these and/or other cavity formation techniques is possible in exemplary embodiments.

In an exemplary embodiment, it is also possible that the high frequency dielectric can be directly pressed or laminated within electrically insulating material (which can for example be composed of multiple layers with already formed recesses) together with a copper foil (based on which subsequently the antenna structure and electrically conductive connections can be manufactured in one common procedure). Further alternatively, it is possible to use an already patterned, optionally also multi-layer, high-frequency inlay which can be implemented in the component carrier compound in form of the stack. In the latter embodiment, the formation of electrically conductive contacts may be carried out thereafter.

In an embodiment, in which both opposing main surfaces of the high-frequency dielectric are covered with separate antenna structures with different properties, it may be advantageous to integrate an electromagnetic radiation shielding material (in particular inhibiting or even eliminating propagation of electromagnetic radiation in the high frequency regime through this material) between the two outer surfaces of the high-frequency material.

In yet another exemplary embodiment, multiple high-frequency dielectric layers may be implemented in one and the same component carrier. In such an embodiment, it can be advantageous, depending on the field of application of the antenna structure(s), to integrate one or more separate shielding layers which can extend over a part or over the entire component carrier.

In all embodiments of the invention, it is possible to additionally provide one or more shielding vias in order to additionally protect the antenna signals. Also the integration of one or more air gaps is possible.

In a preferred embodiment, an analog high-frequency region of the component carrier may be implemented as inlay in an interior of the component carrier. As a result, an antenna structure may be arranged (in particular directly) on the high-frequency dielectric (in particular on one main surface thereof, or both opposing main surfaces thereof). Highly advantageously, it is possible that different antenna structures of a common component carrier realize different radiofrequency functions (for instance a wide range function versus a near field communication function).

Such a concept has the advantage that an antenna structure (retracted into a cavity) of a component carrier may be properly protected with regard to exterior influences. This design architecture also allows the implementation of multiple antenna structures in one component carrier, in particular using one and the same high-frequency dielectric for accommodating at least two different antenna structures. Furthermore, a significant cost reduction may be obtained by the use of inlay-type high-frequency dielectric bodies rather than full layers.

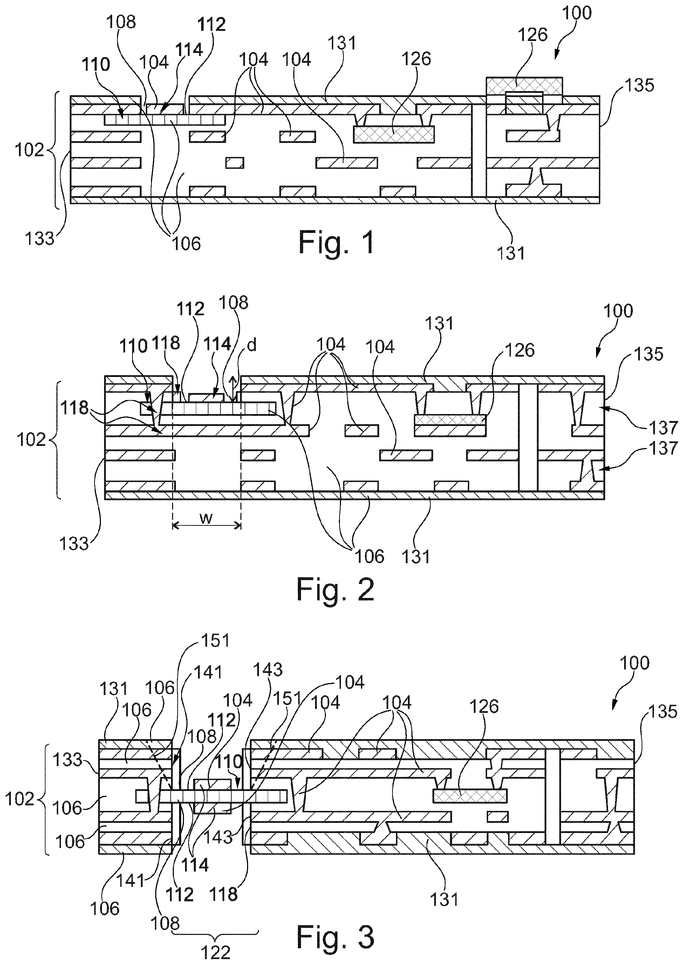

**Figure 1** illustrates a cross-sectional view of a component carrier 100, which is here embodied as a printed circuit board (PCB), according to an exemplary embodiment of the invention.

The plate-shaped laminate-type component carrier 100 comprises a laminated stack 102 of component carrier material comprising a plurality of electrically conductive layer structures 104 (here embodied as patterned metal foils and metal vias, both preferably made of copper) and a plurality of electrically insulating layer structures 106 (here embodied as resin layers, in particular epoxy based resin layers, with reinforcing fibers, in particular glass fibers, for example prepreg). An uppermost layer of the stack 102 forming part of the exterior surface of the component carrier 100 is a solder mask 131. A further solder mask 131 is provided at an opposing other main surface of the component carrier 100, i.e. at a lower main surface of the stack 102 according to Figure 1.

As can be taken from Figure 1, a cavity 108 is formed as a blind hole-type recess in an upper main surface of the stack 102. A high-frequency dielectric 110 forms part of the stack 102 and forms a bottom 112 of the cavity 108. The high-frequency dielectric 110 may be made of a material (such as RO3300^{™} available from Rogers Corporation) showing low loss when high-frequency signals propagate in an environment of the high-frequency dielectric 110, in particular at an antenna structure 114. The material of the high-frequency dielectric 110 may be a ceramic filled plastic with a dissipation factor (tanδ) of less than 0.003 at a high-frequency of 10 GHz. Appropriate materials can be used for frequencies of 60 GHz and more. For instance, the following materials from Rogers Corporation may be used: RO3003^{™}, RO3006^{™}, RO3010^{™}, RO3035^{™}, which all meet the mentioned condition in terms of the dissipation factor. The high-frequency dielectric 110 is here formed as an inlay rather than as a complete layer of the stack 102. Thus, the high-frequency dielectric 110 forms only part of one of the electrically insulating layer structures 106. In other words, a lateral extension of the high-frequency dielectric 110 beyond the lateral limits of the cavity 108 is not up to opposing exterior side walls 133, 135 of the stack 102. As a result, a respective portion of ordinary prepreg of a corresponding one of the electrically insulating layer structures 106 bridges the opposing lateral ends of the high-frequency dielectric 110 with regard to the sidewalls 133, 135.

The already mentioned antenna structure 114 may be formed as a portion of a patterned metal layer of the electrically conductive layer structure 104 being arranged on the high-frequency dielectric 110 and being exposed with regard to an environment of the component carrier 100 within the cavity 108. Hence, the antenna structure 114 is formed as a sub-portion of a patterned one of the plurality of electrically conductive layer structures 104. As can be taken from Figure 1, the antenna structure 114 is entirely located within the cavity 108. The antenna structure 114 is configured as a directional antenna structure 114 being capable of emitting electromagnetic radiation in the high-frequency regime predominantly into a predefined direction.

Moreover, the component carrier 100 comprises two electronic components 126, which may for instance be semiconductor chips. One of the electronic components 126 is surface mounted on an upper main surface of the stack 102. The other one of the electronic components 126 is embedded in an interior of the stack 102. Both electronic components 126 may be electrically coupled with the antenna structure 114 via the electrically conductive layer structures 104. Alternatively, it is however also possible that only a single electronic component 126 (as in the embodiments of Figure 2 to Figure 5) is provided, or even no electronic components 126 is provided at all. In the presence of one or more electronic components 126, the latter may for instance comprise a controller chip for generating a signal to be sent to the antenna structure 114. Additionally or alternatively, an electronic component 126 may be configured for further processing an electric signal supplied from the antenna structure 114.

For an even better performance (in particular in a high-frequency region), in particular in terms of signal integrity, it may be advantageous that a signal processing component and/or a signal generating component is arranged (for instance on a bottom side) on the same layer (in particular at the same height level) as the antenna structure. This has the advantage that vertical interconnects (such as copper vias) between the antenna structure and the respective component may be prevented. Since a change of the geometric shape between line and via may negatively influence signal transmission, the avoidance or at least reduction of vias may further improve the performance of the component carrier.

By retracting or recessing the antenna structure 114 completely into the cavity 108 of the stack 102 rather than surface mounting the antenna structure 114 at an exterior main surface of the component carrier 100, a protection of the tiny antenna structure 114 with regard to the environment of the component carrier 100 is accomplished. The surface topography according to Figure 1 can nevertheless be kept very small, since only a single copper layer and the solder mask 131 are arranged above the high-frequency dielectric 110. Moreover, by configuring the high-frequency dielectric 110 as a spatially limited inlay rather than as a full layer extending over the entire lateral width of the component carrier 100, the component carrier 100 may be manufactured with both high functionality and low cost. At the same time, the spatial extension of a material bridge between the high-frequency dielectric 110 and surrounding prepreg material of the electrically insulating layer structures 106 may be kept small, thereby further improving mechanical integrity of the component carrier 100.

**Figure 2** illustrates a component carrier 100 according to an embodiment not belonging to the invention.

According to Figure 2, a depth, d, of the cavity 108 is larger than in the embodiment of Figure 1. As a result, a ratio between a maximum depth, d, and a maximum width, w, of the cavity 108 is larger than 0.3. As a consequence, the cavity 108 is configured and the antenna structure 114 is arranged in the cavity 108 so that the cavity 108 forms a pronounced horn for the antenna structure 114. Such a horn shape may be adjusted by a corresponding setting of the slanting angle (or even slanting gradient) of sidewalls of the cavity 108. In one embodiment, the sidewalls of the cavity 108 have a constant slanting angle which may be an acute angle of larger than 0° and smaller than 90°, for instance in a range between 10° and 80°. In another embodiment, the sidewalls of the cavity 100 may be vertical (corresponding to an angle of 90°). In yet another embodiment, a slanting angle may vary between a bottom and a top end of the cavity 108, for instance in a concave or convex manner. This may make it possible to refine the adjustment of the directional properties of the antenna structure 114. This allows both an efficient emission of electromagnetic radiation by the antenna structure 114 as well as an efficient absorption of surrounding electromagnetic radiation by the antenna structure 114.

As indicated by reference numeral 137 in Figure 2, it may be advantageous that the build-up is at least partially symmetric in a vertical direction, depending on the dielectric material used.

Advantageously, the component carrier 100 according to Figure 2 comprises an electromagnetic radiation shielding structure 118 configured for shielding electromagnetic radiation from propagating between the antenna structure 114 and at least part of the stack 102. In the embodiment of Figure 2, this is accomplished by metallic material of a patterned copper layer and copper vias next to the high-frequency dielectric 110. Highly advantageously, such an electromagnetic radiation shielding structure 118 may be made of a magnetic material.

**Figure 3** illustrates a component carrier 100 according to an embodiment not belonging to the invention.

In the embodiment of Figure 3, two cavities 108 are formed in two opposing main surfaces of the component carrier 100. In other words, compared to the embodiment of Figure 1 and Figure 2, the embodiment of Figure 3 additionally comprises a further cavity 108 in a lower main surface of the stack 102. Correspondingly, a further antenna structure 114 is arranged exposed and retracted in the further cavity 108 and is formed as a portion of a corresponding one of the electrically conductive layer structures 104. Thus, the cavity 108 and the further cavity 108 are formed in opposing main surfaces of the stack 102. Accordingly, the antenna structure 114 and the further antenna structure 114 are arranged on opposing main surfaces of the same high-frequency dielectric 110. For example, it is possible that the upper antenna structure 114 is configured for a first function, for instance near field communication (NFC). The further antenna structure 114 may be configured for a second function, such as a wide range communication capability. By taking this measure, a component carrier 100 can be provided providing a sophisticated high-frequency functionality with a compact design.

As can be taken from Figure 3, the cavities 108 are vertically aligned or are vertically in flush with one another. The cavities 108 with their antenna structures 114 are delimited laterally by exposed sidewalls 141, 143 and horizontally by exposed opposing surface portions of the high-frequency dielectric 110. It is for instance possible that the high-frequency dielectric 110 is embodied as a single layer carrying both antenna structures 114. The described double-sided antenna configuration of Figure 3 allows to manufacture the component carrier 100 with powerful high-frequency functions and nevertheless compact and with low effort.

As a result of the single layer composition of the high-frequency dielectric 110 which alone vertically separates the cavities 108 from one another, a flex region 122 being flexibly bendable is formed. Thus, the component carrier 100 of Figure 3 can be configured as a rigid-flex board. As can be taken from Figure 3, a central portion of the high-frequency dielectric 110 is located within the flex region 122. Alternative embodiments of the invention provide a component carrier 100 being fully flexible or fully rigid.

In the embodiment of Figure 3, the electromagnetic radiation shielding structure 118 forms at least a part of a boundary wall of the cavities 108. In this embodiment, the sidewalls 141, 143 are at least partially coated (for instance by plating) with electrically conductive material such as copper. When sidewalls 141, 143 of the cavity 108 are coated with metallic or magnetic material, they can be simultaneously be made of a material being reflective for electromagnetic radiation emitted and/or detected by the antenna structure 114. This further increases the efficiency of handling electromagnetic radiation energy by the component carrier 100.

Again referring to the high-frequency dielectric 110 of Figure 3, such a high-frequency layer 110 may be embodied either as a single layer or may also be composed of several sub-layers including flex material and/or reinforced material in between to maintain stiffness, if desired.

In particular, it may be advantageous that the cavity 108 is tapering towards the antenna structure 114, in particular has a substantially conical or frustoconical shape, to further improve the efficiency of emitting and/or absorbing radio frequency radiation by the antenna structure 114. Reference numeral 151 indicates schematically as to how the sidewalls 141, 143 may be slanted (for instance by carrying out a corresponding material removal process) for forming a tapering horn. This may allow further refining the antenna function of the component carrier 100.

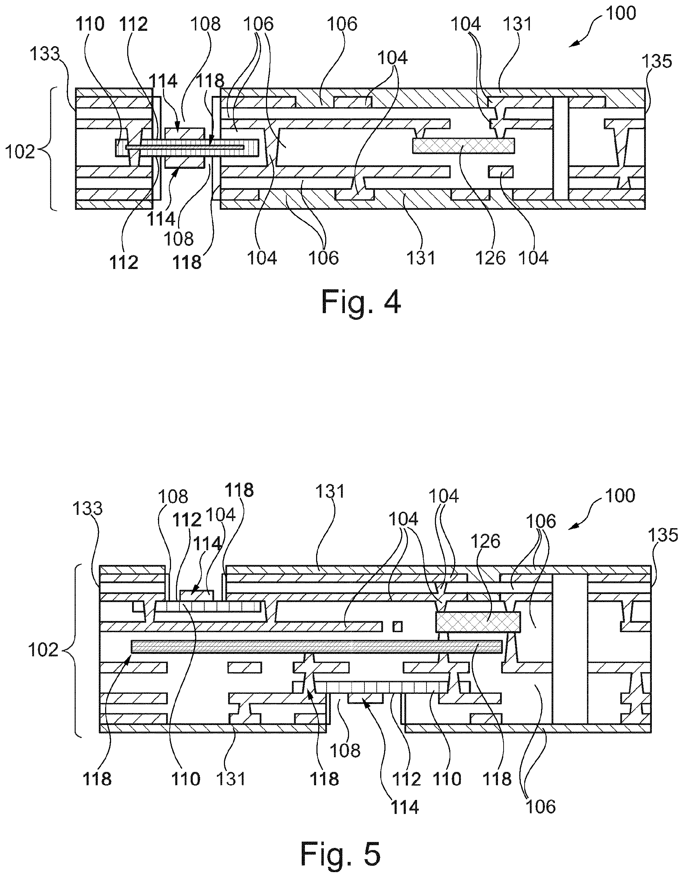

**Figure 4** illustrates a component carrier 100 according to an embodiment not belonging to the invention.

In the embodiment of Figure 4, the above described electromagnetic radiation shielding structure 118 configured for shielding electromagnetic radiation from propagating between the antenna structure 114 and at least part of the stack 102 may be (in particular partially or completely) integrated in (in particular an interior of) the high-frequency dielectric 110. Thus, the electromagnetic radiation shielding structure 118 may be integrated in the high-frequency dielectric 110. This is in particular advantageous for double-sided antenna configurations, as shown for instance in Figure 3 and Figure 4. As a result, the electromagnetic radiation shielding structure 118 of Figure 4 is arranged in a compact way and particularly efficient for shielding electromagnetic radiation from propagating between the antenna structure 114 and the further antenna structure 114. Hence, also in the embodiment of Figure 4, the high-frequency dielectric 110 may be made of multiple layers which may include a special shielding material. The electromagnetic radiation shielding structure 118 can also be embodied as a stack of electrically conductive layer structures and/or electrically insulating layer structures.

**Figure 5** illustrates a component carrier 100 according to an embodiment not belonging to the invention.

The embodiment of Figure 5 differs from the embodiment of Figure 4 in particular in that, in Figure 5, the antenna structure 114 and the further antenna structure 114 are arranged in laterally displaced regions of the stack 102 rather than being aligned with one another in the vertical direction. Furthermore, the electromagnetic radiation shielding structure 118 is integrated, in the embodiment of Figure 5, into a portion of the stack 102 apart from the here two different high-frequency dielectrics 110. Again, also shielding vias 118 contribute to the electromagnetic radiation shielding function in the embodiment of Figure 5.

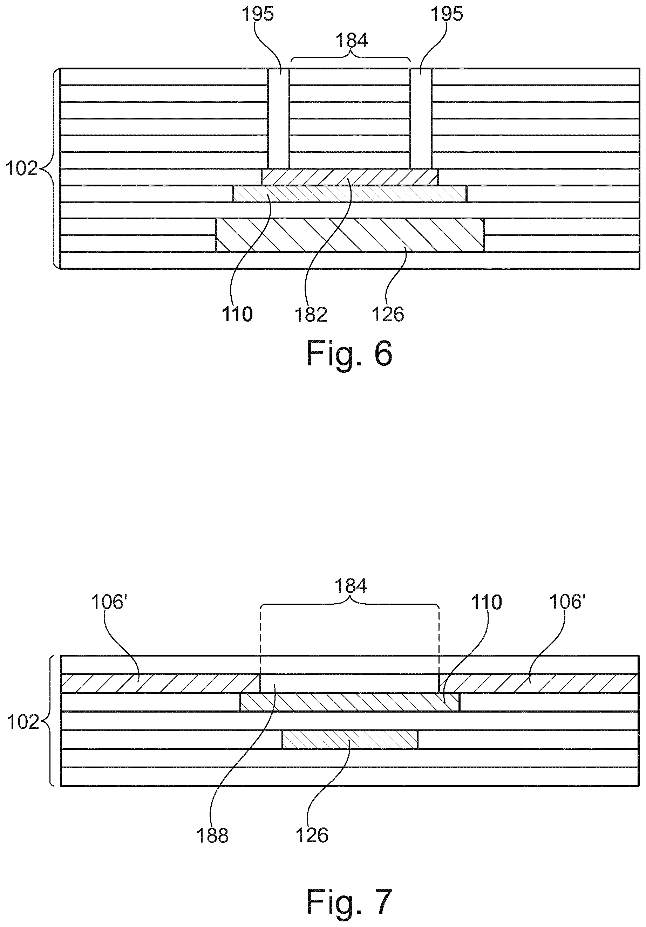

**Figure 6** shows a cross-sectional view of a structure obtained during carrying out a method of manufacturing a cavity 108 of a component carrier 100 (see Figure 1 to Figure 5) according to an exemplary embodiment of the invention.

According to Figure 6, the cavity 108 is formed by arranging a release layer 182 in an interior of the connected, in particular laminated, stack 102. Subsequently, it is possible to cut through a portion of the interconnected, in particular laminated, stack 102 above the release layer 182 to thereby form a circumferential cut out hole 195 allowing to remove a cut-out portion 184 of the connected, in particular laminated, stack 106 above the release layer 182. Advantageously, the (for instance waxy) release layer 182 does not adhere to the rest of the stack 102.

Figure 6 hence illustrates how a cavity 108 can be formed. The connected, in particular laminated, stack 102 has the embedded release layer 182, for instance made of wax. When a circumferential hole is drilled (see reference numeral 195), for example by laser or mechanical drilling, an annular structure of the release layer 182 is exposed. Cut-out portion 184 within the circumferential drill hole can be simply taken out and removed from the remainder of the shown semifinished component carrier 100, since the release layer 182 lacks any significant adhesion to the layers above and below of it. After having taken out this cut-out portion 184, the high-frequency dielectric 110 below the release layer 182 is exposed so that the antenna structure 114 (not shown) can be mounted there and can be electrically connected to the already embedded component 126.

**Figure 7** shows a cross-sectional view of a structure obtained during carrying out a method of manufacturing a cavity 108 of a component carrier 100 (see Figure 1 to Figure 5) according to another exemplary embodiment of the invention.

According to Figure 7, the cavity 108 is formed by forming a hollow space 188 in an interior of the connected, in particular laminated, stack 102, and removing a cut-out portion 184 of the interconnected, in particular laminated, stack 102 above the hollow space 188.

In the shown embodiment, the buried through-hole or hollow space 188 can be formed by laminating within the stack 102 an electrically insulating layer structure 106' of no flow prepreg or low flow prepreg with preformed cut-out inside. During lamination, no resin will hence flow from electrically insulating layer structure 106' in the buried hollow space 188, which will therefore be maintained here. Thereafter, a circumferential cut-out of the material above the buried hollow space 188 will allow to take out section or portion 184, thereby obtaining a cavity 108 on top of high-frequency dielectric 110 for mounting antenna structure 114 (not shown) therein.

As a further alternative to the latter mentioned embodiment, it is possible that all electrically insulating layer structures 106 above the high-frequency dielectric 110 are made of a low-flow prepreg or no-flow prepreg which does not (or at least not substantially) re-melt during lamination. Thus, the use of pre-cut low-flow or no-flow prepreg avoids the need to later expose a cavity 108.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A component carrier (100), wherein the component carrier (100) comprises:
a stack (102) comprising a plurality of electrically conductive layer structures (104) and/or electrically insulating layer structures (106);
a cavity (108) in the stack (102);
a high-frequency dielectric (110) having a dissipation factor of not more than 0.005 at 10 GHz, forming part of the stack (102) and forming at least part of a bottom (112) of the cavity (108);
an antenna structure (114) arranged on the high-frequency dielectric (110) and within the cavity (108);
wherein the high-frequency dielectric (110) is configured as an inlay being at least partially surrounded by material of the stack (102) both in a lateral and in a vertical direction;
wherein a lateral extension of the high-frequency dielectric (110) is beyond the lateral limits of the cavity (108) but not up to opposing exterior side walls (133, 135) of the stack (102); and
wherein the antenna structure (114) in the cavity (108) is exposed with regard to an environment of the component carrier (100); and
wherein only a single electrically conductive layer structure (104) and a solder mask (131) are arranged above the high-frequency dielectric (110).

2. The component carrier (100) according to claim 1, wherein the antenna structure (114) is formed as at least part of a patterned one of the plurality of electrically conductive layer structures (104); and/or
wherein the antenna structure (114) is entirely located within the cavity (108).

3. The component carrier (100) according to any of claims 1 to 2, wherein sidewalls (141, 143) of the cavity (108) are made of a material being reflective for electromagnetic radiation emittable and/or detectable by the antenna structure (114).

4. The component carrier (100) according to any of claims 1 to 3, wherein the antenna structure (114) is configured as a directional antenna structure (114).

5. The component carrier (100) according to any of claims 1 to 4, wherein the high-frequency dielectric (110) forms only part of one of the electrically insulating layer structures (106).

6. The component carrier (100) according to any of claims 1 to 5, comprising an electromagnetic radiation shielding structure (118) configured for shielding electromagnetic radiation from propagating between the antenna structure (114) and at least another portion of the component carrier (100), in particular wherein the electromagnetic radiation shielding structure (118) is at least partially integrated in the high-frequency dielectric (110),
more in particular wherein at least part of the electromagnetic radiation shielding structure (118) forms part of a boundary wall (141, 143) of the cavity (108).

7. The component carrier (100) according to any of claims 1 to 6, comprising at least one of the following features:
the component carrier (100) further comprising at least one component (126), in particular at least one electronic component, mounted on and/or embedded in the at least one electrically insulating layer structure (106) and/or the at least one electrically conductive layer structure (104),
in particular wherein the at least one component (126) is selected from a group consisting of an electronic component, an electrically non-conductive and/or electrically conductive inlay, a heat transfer unit, a light guiding element, an energy harvesting unit, an active electronic component, a passive electronic component, an electronic chip, a storage device, a filter, an integrated circuit, a signal processing component, a power management component, an optoelectronic interface element, a voltage converter, a cryptographic component, a transmitter and/or receiver, an electromechanical transducer, an actuator, a microelectromechanical system, a microprocessor, a capacitor, a resistor, an inductance, an accumulator, a switch, a camera, a magnetic element, a further component carrier (100) and a logic chip;
wherein at least one of the electrically conductive layer structures (104) comprises at least one of the group consisting of copper, aluminum, nickel, silver, gold, palladium, and tungsten, any of the mentioned materials being optionally coated with supra-conductive material such as graphene;
wherein at least one of the electrically insulating layer structures (106) comprises at least one of the group consisting of resin, in particular reinforced or non-reinforced resin, for instance epoxy resin or Bismaleimide-Triazine resin, FR-4, FR-5, cyanate ester, polyphenylene derivate, glass, prepreg material, polyimide, polyamide, liquid crystal polymer, epoxy-based Build-Up Film, polytetrafluoroethylene, a ceramic, and a metal oxide;
wherein the component carrier (100) is shaped as a plate;
wherein the component carrier (100) is configured as one of the group consisting of a printed circuit board, and a substrate;
wherein the component carrier (100) is configured as a laminate-type component carrier (100).

8. A method of manufacturing a component carrier (100), wherein the method comprises:
forming a connected stack (102) comprising a plurality of electrically insulating layer structures (106) and/or electrically conductive layer structures (104);
providing the stack (102) with a cavity (108);
providing a high-frequency dielectric (110), having a dissipation factor of not more than 0.005 at 10 GHz, as part of the stack (102) and forming at least part of a bottom (112) of the cavity (108);
forming an antenna structure (114) on the high-frequency dielectric (110) and within the cavity (108);
wherein the high-frequency dielectric (110) is configured as an inlay being at least partially surrounded by material of the stack (102) both in a lateral and in a vertical direction;
wherein a lateral extension of the high-frequency dielectric (110) is beyond the lateral limits of the cavity (108) but not up to opposing exterior side walls (133, 135) of the stack (102); and
wherein the antenna structure (114) in the cavity (108) is exposed with regard to an environment of the component carrier (100), and
wherein only a single electrically conductive layer structure (104) and a solder mask (131) are arranged above the high-frequency dielectric (110).

9. The method according to claim 8, wherein the method comprises forming the cavity (108) by one of the group consisting of:
embedding a release layer (182) in an interior of the stack (102) and subsequently removing stack material above the release layer (182);
forming a hollow space (188), at least partially surrounded by low flow prepreg or no flow prepreg, in an interior of the stack (102) and subsequently removing stack material above the hollow space (188).

10. The method according to claim 9, wherein the method comprises providing the stack (102) with the cavity (108) as a pre-cut hole in low-flow prepreg or no-flow prepreg as at least one of the electrically insulating layer structures (106).

## Patentansprüche

1. Bauteilträger (100), wobei der Bauteilträger (100) Folgendes umfasst:
einen Stapel (102), der eine Mehrzahl von elektrisch leitfähigen Schichtstrukturen (104) und/oder elektrisch isolierenden Schichtstrukturen (106) umfasst;
einen Hohlraum (108) in dem Stapel (102);
ein Hochfrequenzdielektrikum (110) mit einem Verlustfaktor von nicht mehr als 0,005 bei 10 GHz, das einen Teil des Stapels (102) bildet und mindestens einen Teil einer Unterseite (112) des Hohlraums (108) bildet;
eine Antennenstruktur (114), die auf dem Hochfrequenzdielektrikum (110) und innerhalb des Hohlraums (108) angeordnet ist;
wobei das Hochfrequenzdielektrikum (110) als eine Einlage eingerichtet ist, die mindestens teilweise von Material des Stapels (102) sowohl in einer lateralen als auch in einer vertikalen Richtung umgeben ist;
wobei eine laterale Ausdehnung des Hochfrequenzdielektrikums (110) über die lateralen Begrenzungen des Hohlraums (108) hinausgeht, aber nicht bis zu gegenüberliegenden äußeren Seitenwänden (133, 135) des Stapels (102) reicht; und
wobei die Antennenstruktur (114) in dem Hohlraum (108) in Bezug auf eine Umgebung des Bauteilträgers (100) freiliegt; und
wobei nur eine einzige elektrisch leitfähige Schichtstruktur (104) und ein Lötstopplack (131) über dem Hochfrequenzdielektrikum (110) angeordnet sind.

2. Bauteilträger (100) nach Anspruch 1, wobei die Antennenstruktur (114) als mindestens ein Teil einer strukturierten der Mehrzahl von elektrisch leitenden Schichtstrukturen (104) gebildet ist; und/oder
wobei die Antennenstruktur (114) vollständig innerhalb des Hohlraums (108) angeordnet ist.

3. Bauteilträger (100) nach einem der Ansprüche 1 bis 2, wobei Seitenwände (141, 143) des Hohlraums (108) aus einem Material hergestellt sind, das für elektromagnetische Strahlung reflektierend ist, die durch die Antennenstruktur (114) emittierbar und/oder detektierbar ist.

4. Bauteilträger (100) nach einem der Ansprüche 1 bis 3, wobei die Antennenstruktur (114) als eine Richtantennenstruktur (114) eingerichtet ist.

5. Bauteilträger (100) nach einem der Ansprüche 1 bis 4, wobei das Hochfrequenzdielektrikum (110) nur einen Teil von einer der elektrisch isolierenden Schichtstrukturen (106) bildet.

6. Bauteilträger (100) nach einem der Ansprüche 1 bis 5, umfassend eine elektromagnetische Strahlung abschirmende Struktur (118), die zum Abschirmen elektromagnetischer Strahlung von einer Ausbreitung zwischen der Antennenstruktur (114) und mindestens einem anderen Abschnitt des Bauteilträgers (100) eingerichtet ist, wobei insbesondere die elektromagnetische Strahlung abschirmende Struktur (118) mindestens teilweise in das Hochfrequenzdielektrikum (110) integriert ist, und wobei speziell mindestens ein Teil der elektromagnetische Strahlung abschirmenden Struktur (118) Teil einer Begrenzungswand (141, 143) des Hohlraums (108) bildet.

7. Bauteilträger (100) nach einem der Ansprüche 1 bis 6, umfassend mindestens eines der folgenden Merkmale:
der Bauteilträger (100) umfasst ferner mindestens ein Bauteil (126), insbesondere mindestens ein elektronisches Bauteil, das auf mindestens einer elektrisch isolierenden Schichtstruktur (106) und/oder mindestens einer elektrisch leitfähigen Schichtstruktur (104) montiert und/oder darin eingebettet ist,
wobei insbesondere das mindestens eine Bauteil (126) ausgewählt ist aus einer Gruppe bestehend aus einem elektronischen Bauteil, einer elektrisch nichtleitenden und/oder elektrisch leitenden Einlage, einer Wärmeübertragungseinheit, einem Lichtleitelement, einer Energiegewinnungseinheit, einem aktiven elektronischen Bauteil, einem passiven elektronischen Bauteil, einem elektronischen Chip, einer Speichervorrichtung, einem Filter, einer integrierten Schaltung, einem Signalverarbeitungsbauteil, einem Energieverwaltungsbauteil, einem optoelektronischen Schnittstellenelement, einem Spannungswandler, einem kryptographischen Bauteil, einem Sender und/oder Empfänger, einem elektromechanischen Wandler, einem Aktor, einem mikroelektromechanischen System, einem Mikroprozessor, einem Kondensator, einem Widerstand, einer Induktivität, einem Akkumulator, einem Schalter, einer Kamera, einem magnetischen Element, einem weiteren Bauteilträger (100) und einem Logikchip;
wobei mindestens eine der elektrisch leitfähigen Schichtstrukturen (104) mindestens eines aus der Gruppe bestehend aus Kupfer, Aluminium, Nickel, Silber, Gold, Palladium und Wolfram umfasst, wobei jedes der genannten Materialien optional mit supraleitendem Material wie Graphen beschichtet ist;
wobei mindestens eine der elektrisch isolierenden Schichtstrukturen (106) mindestens eines aus der Gruppe bestehend aus Harz, insbesondere verstärktem oder unverstärktem Harz, beispielsweise Epoxidharz oder Bismaleimid-Triazin-Harz, FR.-4, FR.-5, Cyanatester, Polyphenylenderivat, Glas, Prepreg-Material, Polyimid, Polyamid, Flüssigkristallpolymer, Aufbaufilm auf Epoxidbasis, Polytetrafluorethylen, eine Keramik und einem Metalloxid umfasst;
wobei der Bauteilträger (100) als eine Platte geformt ist;
wobei der Bauteilträger (100) als eines aus der Gruppe bestehend aus einer Leiterplatte und einem Substrat eingerichtet ist;
wobei der Bauteilträger (100) als ein laminatartiger Bauteilträger (100) eingerichtet ist.

8. Verfahren zum Herstellen eines Bauteilträgers (100), wobei das Verfahren umfasst:
Bilden eines verbundenen Stapels (102), umfassend eine Mehrzahl von elektrisch isolierenden Schichtstrukturen (106) und/oder elektrisch leitfähigen Schichtstrukturen (104);
Bereitstellen des Stapels (102) mit einem Hohlraum (108);
Bereitstellen eines Hochfrequenzdielektrikums (110), das einen Verlustfaktor von nicht mehr als 0,005 bei 10 GHz aufweist, als Teil des Stapels (102) und das mindestens einen Teil einer Unterseite (112) des Hohlraums (108) bildet;
Bilden einer Antennenstruktur (114) auf dem Hochfrequenzdielektrikum (110) und innerhalb des Hohlraums (108);
wobei das Hochfrequenzdielektrikum (110) als eine Einlage eingerichtet ist, die mindestens teilweise von Material des Stapels (102) sowohl in einer lateralen als auch in einer vertikalen Richtung umgeben ist;
wobei eine laterale Ausdehnung des Hochfrequenzdielektrikums (110) über die lateralen Begrenzungen des Hohlraums (108) hinausgeht, aber nicht bis zu gegenüberliegenden äußeren Seitenwänden (133, 135) des Stapels (102) reicht; und
wobei die Antennenstruktur (114) in dem Hohlraum (108) in Bezug auf eine Umgebung des Bauteilträgers (100) freiliegt, und
wobei nur eine einzige elektrisch leitfähige Schichtstruktur (104) und ein Lötstopplack (131) über dem Hochfrequenzdielektrikum (110) angeordnet sind.

9. Verfahren nach Anspruch 8, wobei das Verfahren das Bilden des Hohlraums (108) durch eines aus der Gruppe umfasst, die aus Folgendem besteht:
Einbetten einer Trennschicht (182) in ein Inneres des Stapels (102) und anschließendes Entfernen von Stapelmaterial oberhalb der Trennschicht (182);
Bilden eines Hohlraums (188), der mindestens teilweise von Low-Flow-Prepreg oder No-Flow-Prepreg umgeben ist, in einem Inneren des Stapels (102) und anschließendes Entfernen von Stapelmaterial oberhalb des Hohlraums (188).

10. Verfahren nach Anspruch 9, wobei das Verfahren das Bereitstellen des Stapels (102) mit dem Hohlraum (108) als ein vorgeschnittenes Loch in Low-Flow-Prepreg oder No-Flow-Prepreg als mindestens eine der elektrisch isolierenden Schichtstrukturen (106) umfasst.

## Revendications

1. Support de composants (100), dans lequel le support de composants (100) comprend :
un empilement (102) comprenant une pluralité de structures de couches électroconductrices (104) et/ou de structures de couches électro-isolantes (106) ;
une cavité (108) dans l'empilement (102) ;
un diélectrique haute fréquence (110) ayant un facteur de dissipation non supérieur à 0,005 à 10 GHz, formant une partie de l'empilement (102) et formant l'au moins une partie d'un fond (112) de la cavité (108) ;
une structure d'antenne (114) agencée sur le diélectrique haute fréquence (110) et à l'intérieur de la cavité (108) ;
dans lequel le diélectrique haute fréquence (110) est configuré comme une incrustation qui est au moins partiellement entouré par le matériau de l'empilement (102) à la fois dans une direction latérale et dans une direction verticale ;
dans lequel une extension latérale du diélectrique haute fréquence (110) est au-delà des limites latérales de la cavité (108) mais pas jusqu'à des parois latérales extérieures opposées (133, 135) de l'empilement (102) ; et
dans lequel la structure d'antenne (114) dans la cavité (108) est exposée par rapport à un environnement du support de composants (100) ; et
dans lequel une seule structure de couches électroconductrices (104) et un masque de soudure (131) sont agencés au-dessus du diélectrique haute fréquence (110).

2. Support de composants (100) selon la revendication 1, dans lequel la structure d'antenne (114) est formée en tant qu'au moins une partie d'une structure à motifs de la pluralité de structures de couches électroconductrices (104) ; et/ou
dans lequel la structure d'antenne (114) est entièrement située à l'intérieur de la cavité (108).

3. Support de composants (100) selon l'une quelconque des revendications 1 à 2, dans lequel les parois latérales (141, 143) de la cavité (108) sont faites d'un matériau réfléchissant le rayonnement électromagnétique pouvant être émis et/ou détecté par la structure d'antenne (114).

4. Support de composants (100) selon l'une quelconque des revendications 1 à 3, dans lequel la structure d'antenne (114) est configurée comme une structure d'antenne directionnelle (114).

5. Support de composants (100) selon l'une quelconque des revendications 1 à 4, dans lequel le diélectrique haute fréquence (110) ne fait qu'une partie de l'une des structures de couches électro-isolantes (106).

6. Support de composants (100) selon l'une quelconque des revendications 1 à 5, comprenant une structure de protection contre le rayonnement électromagnétique (118) configurée pour empêcher les rayonnements électromagnétiques de se propager entre la structure d'antenne (114) et l'au moins une autre partie du support de composants (100), en particulier dans lequel la structure de protection contre le rayonnement électromagnétique (118) est au moins partiellement intégrée dans le diélectrique haute fréquence (110), plus particulièrement dans lequel au moins une partie de la structure de protection contre le rayonnement électromagnétique (118) fait partie d'une paroi de délimitation (141, 143) de la cavité (108).

7. Support de composant (100) selon l'une quelconque des revendications 1 à 6, comprenant au moins l'une des caractéristiques suivantes :
le support de composant (100) comprenant en outre l'au moins un composant (126), en particulier l'au moins un composant électronique, monté sur et/ou incorporé dans l'au moins une des structures de couches électriquement isolantes (106) et/ou l'au moins une des structures de couches électroconductrices (104), en particulier dans lequel l'au moins un composant (126) est sélectionné dans un groupe constitué par un composant électronique, une incrustation électriquement non conductrice et/ou électriquement conductrice, une unité de transfert de chaleur, un élément de guidage de lumière, une unité de collecte d'énergie, un composant électronique actif, un composant électronique passif, une puce électronique, un dispositif de stockage, un filtre, un circuit intégré, un composant de traitement de signal, un composant de gestion de puissance, un élément d'interface optoélectronique, un convertisseur de tension, un composant cryptographique, un émetteur et/ou un récepteur, un transducteur électromécanique, un actionneur, un système microélectromécanique, un microprocesseur, un condensateur, une résistance, une inductance, un accumulateur, un commutateur, une caméra, un élément magnétique, un autre support de composant (100) et une puce logique ;
dans lequel au moins l'une des structures de couches électriquement conductrices (104) comprend au moins l'un parmi le groupe constitué par le cuivre, l'aluminium, le nickel, l'argent, l'or, le palladium, et le tungstène, l'un quelconque des matériaux mentionnés étant éventuellement revêtu d'un matériau supraconducteur tel que le graphène ;
dans lequel au moins une des structures de couches électriquement isolantes (106) comprend au moins un élément du groupe constitué par une résine, en particulier la résine renforcée ou non renforcée, par exemple la résine époxy ou la résine bismaléimide-triazine, FR-4, FR-5, l'ester de cyanate, un dérivé de polyphénylène, le verre, un matériau préimprégné, le polyimide, le polyamide, un polymère à cristaux liquides, un film d'accroissement à base époxy, le polytétrafluoroéthylène, une céramique et un oxyde métallique ;
dans lequel le support de composants (100) est formé comme une plaque ;
dans lequel le support de composants (100) est configuré comme l'un parmi le groupe constitué par une carte de circuit imprimé et un substrat ;
dans lequel le support de composant (100) est conçu sous la forme d'un support de composant (100) de type stratifié.

8. Procédé de fabrication d'un support de composants (100), dans lequel le procédé comprend :
la formation d'un empilement (102) connecté comprenant une pluralité de structures de couches électro-isolantes (106) et/ou de structures de couches électroconductrices (104) ;
la fourniture de l'empilement (102) avec une cavité (108) ;
la fourniture d'un diélectrique haute fréquence (110) ayant un facteur de dissipation non supérieur à 0,005 à 10 GHz, comme une partie de l'empilement (102) et formant l'au moins une partie d'un fond (112) de la cavité (108) ;
la formation d'une structure d'antenne (114) sur le diélectrique haute fréquence (110) et à l'intérieur de la cavité (108) ;
dans lequel le diélectrique haute fréquence (110) est configuré comme une incrustation qui est au moins partiellement entouré par le matériau de l'empilement (102) à la fois dans une direction latérale et dans une direction verticale ;
dans lequel une extension latérale du diélectrique haute fréquence (110) est au-delà des limites latérales de la cavité (108) mais pas jusqu'à des parois latérales extérieures opposées (133, 135) de l'empilement (102) ; et
dans lequel la structure d'antenne (114) dans la cavité (108) est exposée par rapport à un environnement du support de composants (100), et
dans lequel une seule structure de couches électroconductrices (104) et un masque de soudure (131) sont agencés au-dessus du diélectrique haute fréquence (110).

9. Procédé selon la revendication 8, dans lequel le procédé comprend la formation d'une cavité (108) par l'un du groupe constitué par :
l'intégration d'une couche de libération (182) à l'intérieur de l'empilement (102) et ensuite l'élimination du matériau de l'empilement au-dessus de la couche de libération (182) ;
la formation d'un espace creux (188), au moins partiellement entouré par un préimprégné à faible écoulement ou un préimprégné sans écoulement, à l'intérieur de l'empilement (102) et ensuite l'enlèvement du matériau de l'empilement au-dessus de l'espace creux (188).

10. Procédé selon la revendication 9, dans lequel le procédé comprend la fourniture de l'empilement (102) avec la cavité (108) comme un trou prédécoupé dans un préimprégné à faible écoulement ou un préimprégné sans écoulement comme l'au moins une des structures de couches électriquement isolantes (106).
